**Europäisches Patentamt**

**European Patent Office**

**Office européen des brevets**

(19)

(11) **EP 1 475 874 A1**

(12) **DEMANDE DE BREVET EUROPEEN**

(43) Date de publication:
**10.11.2004 Bulletin 2004/46**

(51) Int Cl.⁷: **H02H 3/347**

(21) Numéro de dépôt: **04354016.0**

(22) Date de dépôt: **01.04.2004**

(84) Etats contractants désignés:
**AT BE BG CH CY CZ DE DK EE ES FI FR GB GR HU IE IT LI LU MC NL PL PT RO SE SI SK TR**
Etats d'extension désignés:
**AL HR LT LV MK**

(30) Priorité: **05.05.2003 FR 0305455**

(71) Demandeur: **Schneider Electric Industries SAS 92500 Rueil-Malmaison (FR)**

(72) Inventeurs:
• **Bertrand, Pierre, c/o Schneider El. Ind. SAS 38050 Grenoble Cedex 09 (FR)**
• **Le Pivert, Xavier, c/o Schneider El. Ind. SAS 38050 Grenoble Cedex 09 (FR)**

(74) Mandataire: **Tripodi, Paul et al Schneider Electric Industries SAS, Service Propriété Industrielle - E1 38050 Grenoble Cédex 09 (FR)**

(54) **Dispositif et procédé de détection de défaut terre et relais comportant un tel dispositif**

(57) Le dispositif de détection de défaut terre comporte un conditionneur (22) recevant des signaux (IA, IB, IC) de courants pour fournir des signaux (Ir) et (Ia, Ib, Ic) représentatifs d'un courant résiduel et de courants de phases, et un circuit de traitement (23) connectés au conditionneur pour effectuer une détection de défaut terre aval en fonction desdits signaux (Ir, Ia, Ib, Ic). Ledit circuit de traitement et le procédé de détection signalent un défaut terre aval si une valeur du signal (Ir) de courant résiduel dépasse un premier seuil (S1) prédéterminé, et si un rapport entre une valeur représentative de d'amplitude du courant inverse (Ii) et une valeur représentative d'un signal de courant résiduel (Ir) dépasse un second seuil prédéterminé ou est compris entre deux seuils. Le relais de protection comporte des capteurs de courant, un dispositif de détection, et un actionneur commandé par un signal (D) de détection.

FIG. 4

Printed by Jouve, 75001 PARIS (FR)

## Description

## DOMAINE TECHNIQUE

L'invention concerne un dispositif de détection de défaut terre comportant:

- des moyens de conditionnement de signal destinés à recevoir des signaux de courants pour fournir un signal représentatif d'un courant résiduel et des signaux représentatifs de courants de phases, et
- des moyens de traitement de signal, connectés aux moyens de conditionnement pour recevoir lesdits signaux représentatifs d'un courant résiduel et de courants de phases et pour fournir un signal de détection de défaut terre si ledit signal représentatif de courant résiduel dépasse un premier seuil prédéterminé.

L'invention concerne aussi un relais de protection terre comportant des capteurs de courant disposés sur chaque conducteur de phase d'un circuit d'un réseau électrique à surveiller, un dispositif de détection de défaut terre connecté audits capteurs de courant pour recevoir des signaux représentatifs de courants de phases et des moyens d'actionnement connectés audit dispositif de détection de défaut terre.

L'invention concerne aussi procédé de détection de défaut terre comportant une étape de conditionnement de signal pour fournir un signal représentatif d'un courant résiduel et des signaux représentatifs de courant de phases, et une étape de traitement pour signaler une détection de défaut terre aval en fonction desdits signaux représentatifs de courants de résiduel et de phases.

## ETAT DE LA TECHNIQUE

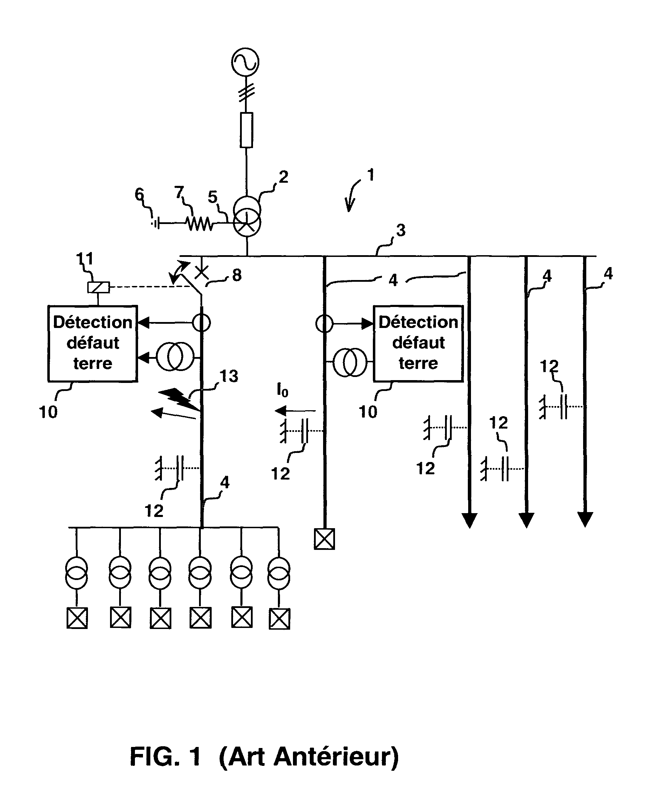

Les dispositifs de détection de défaut à la terre ainsi que les relais comportant de tels dispositifs sont utilisés notamment dans les réseaux de distribution électrique triphasés moyenne tension. Un schéma d'un réseau de distribution électrique est représenté sur la figure 1. Par exemple, un réseau 1 de distribution électrique comporte un transformateur 2 triphasé ayant un secondaire connecté à une ligne principale 3 de distribution alimentant des lignes 4 de départ. Le secondaire du transformateur 2 comporte un conducteur commun de neutre 5 généralement connecté à la terre 6 par une impédance 7. Certaines lignes de départ 4 comportent un disjoncteur 8 pour protéger ladite ligne. Des dispositifs 10 de détection de défaut terre peuvent être disposés sur des lignes ou des tronçons du réseau. Par exemple, des dispositifs de détection 10 associés à des relais 11 peuvent commander l'ouverture des contacts d'un disjoncteur 8.

Lorsque des lignes 4 de départ à protéger sont constituées de câbles enterrés, de fortes valeurs de capacité apparaissent entre les câbles et la terre. Ces capacités représentées par des condensateurs 12 sur la figure 1 font circuler d'importants courants homopolaires Io sur des lignes de départ sans défaut terre lorsqu'un défaut 13 est présent sur un départ voisin.

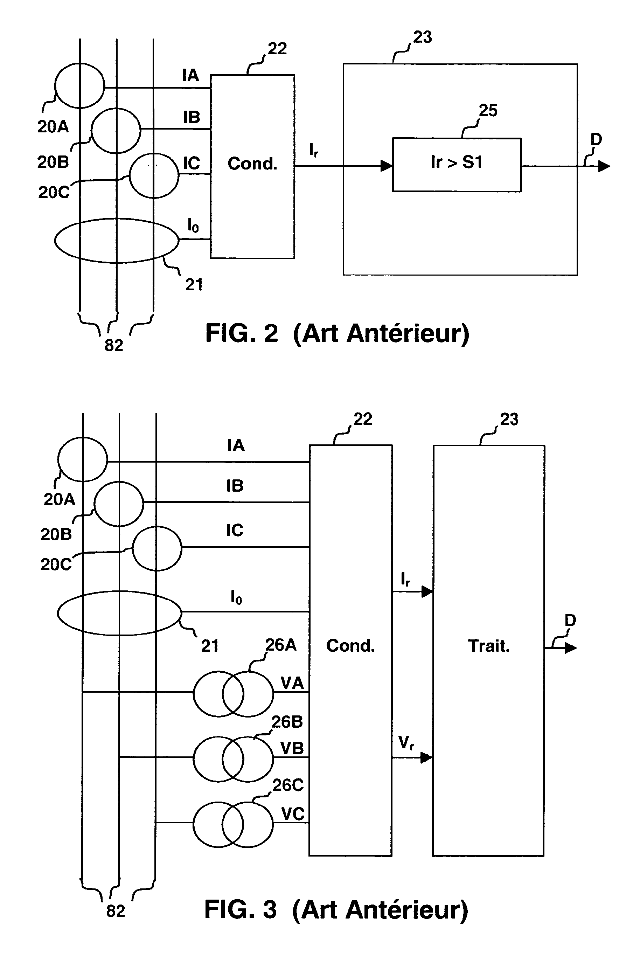

La figure 2 représente un schéma d'un dispositif connu de détection de défaut terre qui utilise des signaux de courant IA, IB, IC fournis par des capteurs de courants 20A, 20B, 20C ou un capteur 21 de courant homopolaire Io entourant des conducteurs principaux 82 de phases. Généralement, le dispositif comporte un circuit de conditionnement 22 pour fournir un signal Ir représentatif d'un courant résiduel à un circuit de traitement 23. Le circuit de traitement comporte un module de protection 25 pour traiter le signal représentatif d'un courant résiduel et pour comparer ledit signal Ir traité à un premier seuil S1. Si le seuil S1 est dépassé, un signal D de détection est fourni pour signaler la détection d'un défaut terre.

Un tel dispositif ne peut pas distinguer un défaut terre en aval, d'un défaut terre en amont détecté par liaison capacitive avec un départ voisin en défaut, en particulier avec des lignes enterrées.

Pour protéger des lignes de départ fortement capacitives, il existe des dispositifs de détection comportant, en plus des capteurs de courant, des transformateurs de tensions pour permettre une détection directionnelle de la protection terre. Un schéma bloc d'un tel dispositif est représenté sur la figure 3. Ainsi, des transformateurs de tension 26A, 26B et 26C fournissent des signaux de tension VA, VB et VC au circuit de conditionnement 22 pour déterminer un signal représentatif d'une tension résiduelle Vr. Le circuit de traitement 23 utilise le signal Ir pour détecter la présence d'un défaut terre et les signaux Ir et Vr pour détecter la direction d'un défaut en aval ou en amont.

Les dispositifs utilisant des transformateurs ou d'autres capteurs de tension sont très volumineux et coûteux. De plus, ils ne sont pas adaptés pour être disposés sur des lignes déjà installées.

## EXPOSE DE L'INVENTION

L'invention a pour but un dispositif et un procédé de détection de défaut terre peu sensibles à des perturbations et évitant l'utilisation de mesure de tension pour détecter un défaut terre, ainsi qu'un relais de protection comportant un tel dispositif.

Dans un dispositif de détection de défaut terre selon l'invention, les moyens de traitement signalent un défaut terre aval si une valeur dudit signal représentatif de courant résiduel dépasse un premier seuil prédéterminé, et si un rapport entre une valeur représentative de d'amplitude du courant inverse et une valeur représentative d'un signal de courant résiduel dépasse au moins un second seuil prédéterminé.

Dans un mode de réalisation préférentiel, lesdits moyens de traitement signalent un défaut terre aval si une valeur dudit signal représentatif de courant résiduel dépasse ledit premier seuil prédéterminé, et si un rapport entre une valeur représentative de d'amplitude du courant inverse et une valeur représentative d'un signal de courant résiduel dépasse au moins ledit second seuil prédéterminé et est inférieure à un troisième seuil prédéterminé.

De préférence, lesdits moyens de traitement comportent :

- des premiers moyens de protection pour recevoir le signal représentatif de courant résiduel et pour fournir un premier signal de détection si une valeur du signal de courant résiduel dépasse un premier seuil prédéterminé, et
- des seconds moyens de protection comportant des moyens de détermination d'un courant inverse connectés aux moyens de conditionnement pour recevoir lesdits signaux représentatifs de courants de phases et pour fournir un signal représentatif d'un courant inverse, lesdits seconds moyens de protection fournissant un second signal de détection si un rapport entre une valeur représentative de d'amplitude du courant inverse et une valeur représentative d'un signal de courant résiduel est compris entre au moins ledit second seuil prédéterminé et ledit troisième seuil prédéterminé,

ledit signal de détection de défaut terre aval étant fourni si au moins ledit premier signal de détection et ledit second signal de détection sont actifs.

Avantageusement, ledit second seuil prédéterminé correspondant à un rapport entre une valeur représentative de d'amplitude du courant inverse et une valeur représentative d'un signal de courant résiduel est inférieur à 1 et ledit troisième seuil prédéterminé correspondant aussi à un rapport entre une valeur représentative de d'amplitude du courant inverse et une valeur représentative d'un signal de courant résiduel est supérieur à 1,2.

De préférence, lesdits moyens de traitement comportent des troisièmes moyens de protection comportant des moyens de détermination d'une valeur représentative d'un courant direct connecté aux moyens de conditionnement pour recevoir lesdits signaux représentatifs de courants de phases et pour fournir un signal représentatif d'une variation d'un courant direct, lesdits troisièmes moyens de protection fournissant un troisième signal de détection si une valeur représentative dudit courant direct ne diminue pas, ledit signal de détection de défaut terre aval étant fournit si au moins ledit premier signal de détection, ledit second signal de détection, et ledit troisième signal de détection sont actifs.

Dans un mode de réalisation particulier, lesdits moyens de conditionnement comportent des moyens de détermination d'un courant résiduel en fonction de courants secondaires fournis par des capteurs de courants de phases et des moyens de détermination d'un signal représentatif d'un harmonique de rang deux d'au moins un signal de courant de phase, et en ce que lesdits moyens de traitement comportent des quatrièmes moyens de protection connectés aux moyens de conditionnement pour recevoir le signal représentatif d'un harmonique de rang deux et pour fournir un signal d'inhibition temporaire à l'enclenchement si ledit signal représentatif d'un harmonique de rang deux est détecté, ledit signal de détection de défaut terre aval n'étant pas fourni pendant une durée prédéterminée si le signal représentatif d'un harmonique de rang deux est détecté à l'enclenchement.

De préférence, ledit signal représentatif d'un harmonique de rang deux est représentatif d'un taux d'harmonique de rang deux dans une combinaison des courants des trois phases.

Selon une première variante, le dispositif comporte un capteur de courant secondaire pour fournir un signal représentatif d'un courant résiduel mesuré sur des enroulements sorties des capteurs de courants de phases.

Selon une seconde variante, les moyens de détermination d'un courant résiduel déterminent ledit signal représentatif d'un courant résiduel en fonction des signaux de courants de phases.

Un relais de protection terre selon l'invention comporte des capteurs de courant disposés sur chaque conducteur de phase d'un circuit d'un réseau électrique à surveiller, au moins un dispositif de détection de défaut terre tel que défini ci-dessus connecté audits capteurs de courant pour recevoir des signaux représentatifs de courants de phases, et des moyens d'actionnement connectés audit dispositif de détection de défaut terre.

Dans un mode de réalisation préférentiel, le relais comporte :

- un transformateur de courant résiduel entourant les conducteurs de phase d'un réseau à surveiller et comportant un enroulement secondaire connecté audit dispositif de détection de défaut terre pour fournir un signal représentatif de courant résiduel, et
- des moyens pour prendre en compte un signal d'inhibition fourni par des quatrièmes moyens de protection.

Un procédé de détection de défaut terre comportant :

- une étape de conditionnement de signal pour fournir un signal représentatif d'un courant résiduel et des signaux représentatifs de courant de phases , et
- une étape de traitement pour signaler une détection de défaut terre aval en fonction desdits signaux représentatifs de courants de résiduel et de phases,

comporte selon un mode de réalisation de l'invention :

- une première étape de protection effectuant un premier test pour tester si un signal représentatif d'un courant résiduel dépasse un premier seuil prédéterminé, et

- une seconde étape de protection effectuant un second test pour tester si un rapport entre un signal représentatif d'un courant inverse et un signal représentatif d'un courant résiduel dépasse un second seuil prédéterminé,

l'étape de traitement signalant une de détection de défaut terre aval si le premier test et le second test sont vrais.

Avantageusement, la seconde étape de protection effectue un second test pour tester si un rapport entre un signal représentatif d'un courant inverse et un signal représentatif d'un courant résiduel est compris entre ledit second seuil prédéterminé et un troisième seuil prédéterminé.

Dans un mode de réalisation préférentiel, le procédé comporte une troisième étape de protection effectuant un troisième test pour tester si un signal représentatif d'un courant direct ne décroît pas lors de la détection d'un défaut terre, l'étape de traitement de signal signalant une détection de défaut terre aval si le premier test, le second test et le troisième test sont vrais.

De préférence, le procédé comporte une quatrième étape de protection pour effectuer une inhibition temporaire la signalisation de la détection de défaut terre aval si un enclenchement est détecté.

**BREVE DESCRIPTION DES DESSINS**

D'autres avantages et caractéristiques ressortiront plus clairement de la description qui va suivre, de modes particuliers de réalisation de l'invention, donnés à titre d'exemples non limitatifs, et représentés aux dessins annexés sur lesquels :

- la figure 1 représente un schéma d'un réseau électrique dans lequel des dispositifs de détection de défaut terre peuvent être utilisés ;

- les figures 2 et 3 représentent des schémas blocs de dispositifs de détection de défauts terre selon des modes de réalisation de l'état de la technique ;

- la figure 4 représente un schéma bloc d'un dispositif de détection de défaut terre selon un premier mode de réalisation de l'invention ;

- la figure 5 représente un exemple de schéma détaillé d'un dispositif selon le mode de réalisation de la figure 4;

- la figure 6 représente un schéma bloc d'un dispositif de détection de défaut terre selon un second mode de réalisation de l'invention ;

- les figures 7 et 8 représentent des schémas partiels de dispositifs fournissant un signal de courant résiduel en utilisant des signaux fournis par des capteurs de courants de phase ;

- la figure 9 représente un schéma bloc d'un relais comportant un dispositif de détection de défaut terre selon un troisième mode de réalisation de l'invention ;

- la figure 10 représente un organigramme d'un procédé de détection selon un mode de réalisation de l'invention.

**DESCRIPTION DETAILLEE DE MODES DE REALISATION PREFERES**

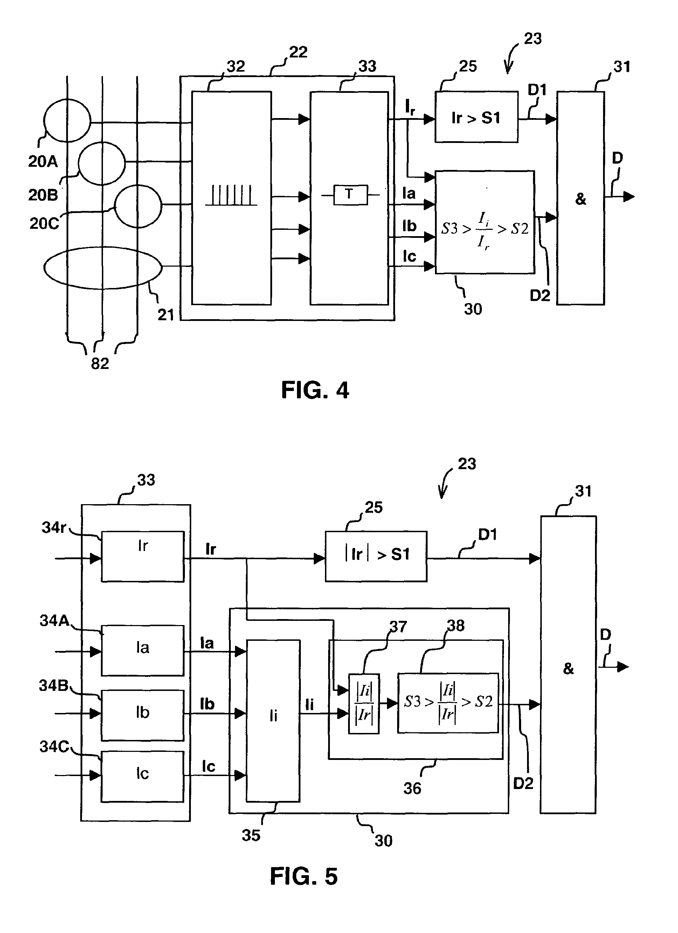

Dans un dispositif de détection de défaut terre selon un mode de réalisation de l'invention représenté sur le schéma de la figure 4, le circuit de conditionnement 22 fournit à un premier module de protection 25 du circuit de traitement un signal Ir représentatif d'un courant résiduel et à un second module de protection 30 du circuit de traitement 23 un signal représentatif d'un courant résiduel Ir et des signaux représentatifs de courants de phase. Le premier module de protection 25 compare le signal Ir représentatif d'un courant résiduel à un premier seuil S1 et fournit un premier signal de détection D1 à un module de décision 31. La comparaison peut aussi être faite avec une valeur absolue |Ir| ou avec l'amplitude du signal représentatif d'un courant résiduel. Le second module de protection 30 détermine un signal Ii représentatif d'un courant inverse, détermine un rapport Ii/Ir entre le signal Ii et le signal Ir puis compare ledit rapport à un second seuil S2 et fournit un second signal de détection D2 au module de décision 31. Le module de décision 31 fournit le signal D de détection de défaut terre aval si le premier signal de détection D1 et le second signal de détection D2 sont actifs ou présents. Avantageusement, le second module de protection 30 fournit le second signal D2 si le rapport Ii/Ir est supérieur au seuil S2 est inférieur à un troisième seuil S3.

Le circuit de conditionnement 22 fournit, de préférence, des signaux représentatifs de courant de phase de type complexe comportant notamment une information d'amplitude et une information angulaire ou de direction. Par exemple, ces signaux peuvent être aussi représentés par des vecteurs, des couples de données, des phaseurs, ou des matrices. Dans un mode de réalisation particulier, le circuit conditionnement 22 comporte un échantillonneur 32 recevant des signaux des capteurs de courant et un module de traitement de signal 33 connecté à l'échantillonneur pour recevoir des signaux échantillonnés et fournir des signaux de forme complexe Ir, Ia, Ib, Ic respectivement représentatifs de courants résiduel et de phases. Par exemple, le module 33 effectue des transformées de Fourier des signaux pour établir des valeurs complexes.

La figure 5 montre un détail du module 33 avec des éléments de traitement de signal 34r, 34A, 34B, et 34C pour traiter respectivement des signaux de courant résiduel et de courant de phases. Le second module de protection 30 comporte, dans ce mode de réalisation, un élément 35 de détermination d'un signal Ii représentatif d'un courant inverse recevant les signaux complexes Ia, Ib, Ic. Le signal Ii est fourni à un élément de protection 36 comportant un élément 37 de détermination d'un rapport Ii/Ir et un élément 38 de comparaison dudit rapport au second seuil S2 et avantageusement au troisième seuil S3 pour fournir le second signal de détection D2. De préférence, le rapport est déterminé en fonction de valeurs absolues des signaux de courant |Ii|/|Ir|. Avantageusement, l'expression du courant Ii peut être la suivante

$$Ii = Ia + \exp(j\,4\pi/3)\,Ib + \exp(j\,2\pi/3)\,Ic.$$

Le second seuil S2 peut être prédéterminé ou réglé à une valeur inférieure à 1, par exemple 0,9 et le troisième seuil S3 peut être déterminé ou réglé en fonction des caractéristiques des lignes du réseau. Par exemple, le seuil S3 peut être supérieur à 1,2. Il peut être aussi réglable entre une valeur basse de 1,2 et une valeur haute supérieure à 1,2. Ainsi, le troisième seuil correspondant à un rapport entre une valeur représentative de l'amplitude du courant inverse et une valeur représentative d'un signal de courant résiduel prédéterminé peut avantageusement être supérieure à une valeur basse de 1,2.

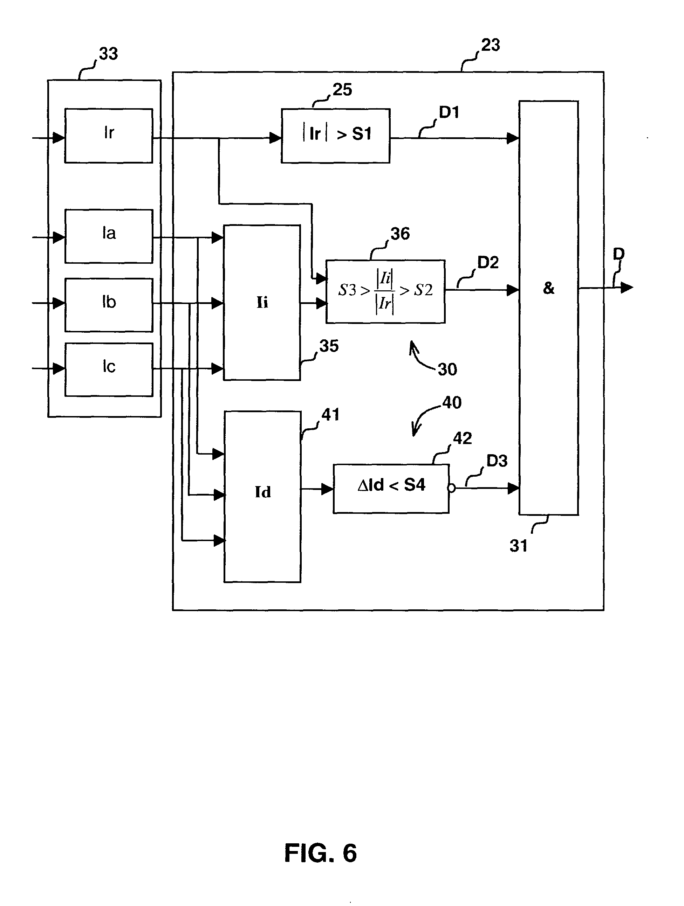

La figure 6 représente un schéma bloc d'un dispositif de détection de défaut terre selon un autre mode de réalisation de l'invention. Le dispositif de détection comporte un troisième module de protection 40 basé sur la variation d'un courant représentatif d'un courant direct Id. Le troisième module de protection permet de détecter un défaut biphasé en amont du dispositif de détection si le courant direct diminue lors d'un défaut. Le module 40 comporte un élément 41 de détermination d'un courant direct Id recevant les signaux de type complexe Ia, Ib, Ic et fournissant un signal ∆Id représentatif d'une variation de courant Id à un élément de comparaison 42. L'élément 42 fournit un troisième signal de détection D3 si la variation du courant direct n'est pas faible notamment inférieure à un seuil S4. Avantageusement, l'expression du courant Id peut être la suivante

$$Id = Ia + \exp(j\,2\pi/3)\,Ib + \exp(j\,4\pi/3)\,Ic.$$

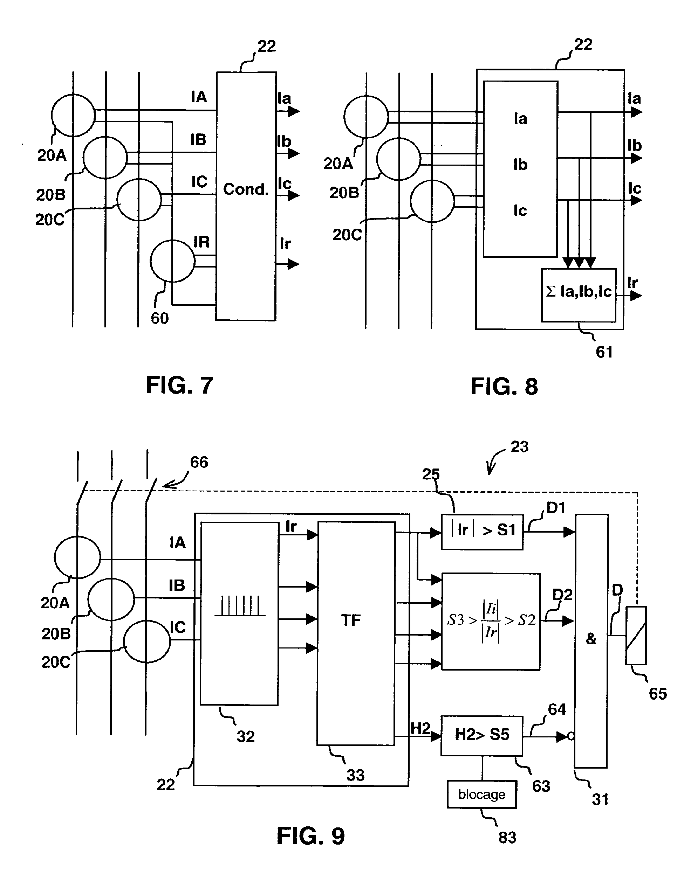

Les figures 7 et 8 représentent des schémas partiels de dispositifs fournissant un signal de courant résiduel en utilisant des signaux fournis par des capteurs de courants de phase. Sur la figure 7, un transformateur de courant 60 est traversé en son primaire par des courants secondaires des capteurs de courants. Le secondaire du transformateur 60 fourni un signal de courant IR représentatif d'un courant homopolaire ou résiduel au circuit de conditionnement qui fournit le signal Ir. Sur la figure 8, le circuit de conditionnement comporte un module de détermination 61 de signal de courant résiduel Ir, en fonction des signaux de phase Ia, Ib, et Ic.

Le module 61 effectue la somme vectorielle ou la somme instantanée des signaux de courant Ia, Ib et Ic pour déterminer le signal de courant Ir.

Dans les deux cas, le courant Ir est déterminé en fonction de courants ou de signaux fournis par les capteurs de courant de phase. Cependant, ces capteurs peuvent saturer ou déformer le signal de courant si des courants élevés sont présents sur les phases, notamment à l'enclenchement de transformateurs. Ces courants élevés de phase peuvent provoquer la détection de faux courants homopolaires.

Un relais de protection comportant un dispositif selon un autre mode de réalisation de l'invention est représenté sur la figure 9. Dans ce dispositif, le module de conditionnement 22 fournit un signal H2 d'harmonique de rang deux ou de taux d'harmonique de rang deux à un cinquième module de protection 63. Le module de protection 63 compare le taux d'harmonique de rang deux à un cinquième seuil S5 et fournit un signal temporaire d'inhibition 64 au module de décision 31. Ce signal 64 bloque la fourniture du signal D à un relais ou à un actionneur 65 pendant une durée prédéterminée pour éviter les effets de faux courants homopolaires à l'enclenchement dus à la saturation des capteurs. Un circuit de blocage 83 connecté au module 63 peut permettre d'activer ou désactiver l'inhibition selon le type de détermination du signal de courant Ir. De préférence, le seuil S5 correspondant à un taux d'harmonique de rang deux est de l'ordre de 0,2. Sur le schéma de la figure 9, le relais électromagnétique ou l'actionneur 65 peuvent actionner l'ouverture de contacts 66 d'un disjoncteur ou d'un interrupteur.

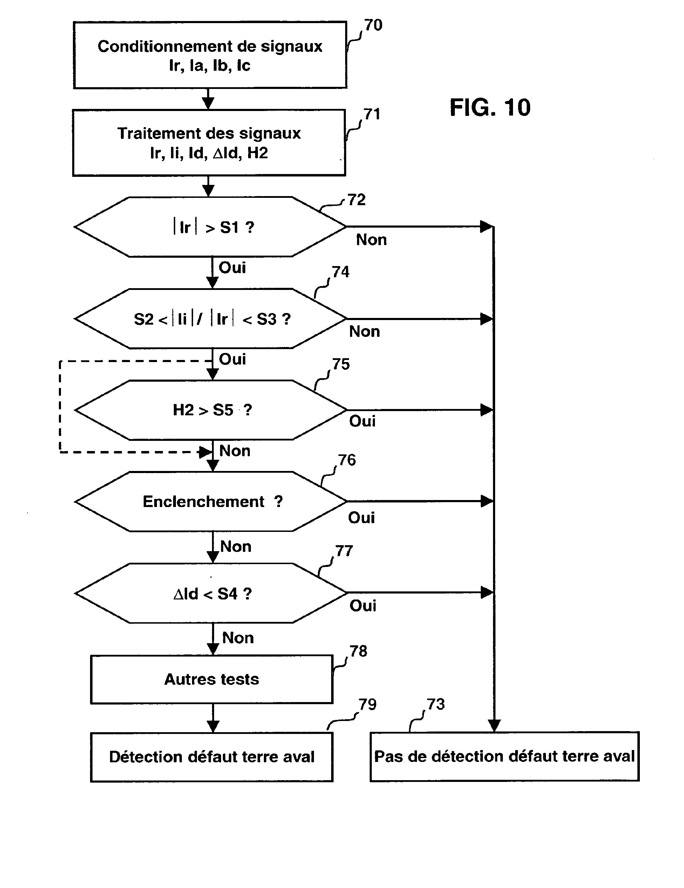

La figure 10 représente un organigramme d'un procédé de détection selon un mode de réalisation de l'invention. Ce procédé comporte une étape 70 de conditionnement pour fournir des valeurs représentatives d'un courant résiduel ou homopolaire Ir et de courant de phase Ia, Ib, Ic. Une étape 71 détermine des valeurs de courant résiduel Ir, de courant inverse Ii, de courant direct Id, de variation de courant direct ∆Id et/ou d'un signal second harmonique H2. Une étape 72 compare le signal de courant résiduel Ir, ou la valeur absolue |Ir| de ce signal, à un premier seuil S1. Si le seuil S1 n'est pas dépassé une étape 73 indique qu'il n'y a pas de défaut terre aval. Si le seuil S1 est dépassé, une étape 74 compare un rapport Ii/Ir ou |Ii|/|Ir| à un second seuil S2 et avantageusement à troisième seuil S3. Si le seuil le seuil S2 n'est pas dépassé ou si ledit rapport n'est pas compris entre le second seuil S2 et troisième seuil S3, l'étape 73 indique qu'il n'y a pas de défaut terre aval.

Si le seuil S2 est dépassé ou avantageusement si le rapport est compris entre le second seuil S2 et troisième seuil S3, une étape 75 compare un taux d'harmonique de rang deux H2 à un cinquième seuil S5. Si le seuil S5 est dépassé, l'étape 73 indique qu'il n'y a pas de défaut terre. L'étape 75 peut être active uniquement si le courant Ir est déterminé en fonction des courants de phases fournis par les sorties des capteurs 20A, 20B, 20C.

Une étape 76 vérifie si un signal extérieur indique un enclenchement d'un transformateur, dans ce cas le traitement est dirigé vers l'étape 73. Sinon une étape 77 détecte si le signal de courant direct Id diminue ou reste stable par exemple si l'écart ∆Id est inférieur à un quatrième seuil S4. Si ∆Id est inférieur au seuil S4, cela signifie qu'il y a un défaut biphasé en amont et le traitement est dirigé vers l'étape 73 pour indiquer qu'il n'y a pas de défaut terre aval. Sinon, une étape 78 peut procéder à d'autres tests avant de diriger le traitement vers l'étape 79 pour indiquer la présence d'un défaut terre en aval. Les étapes 75 à 78 sont des étapes de protection ou de confirmation elles peuvent être utilisées seules, en partie, ou toutes en combinaison. Selon le cas, L'étape 74 peut aussi diriger le traitement directement vers l'étape 79 si le second seuil S2 est dépassé ou avantageusement si le rapport est compris entre les seuils S2 et S3.

Dans les modes de réalisation décrits ci-dessus, les différents circuits, modules et fonctions peuvent être réalisés en composants analogiques, numériques ou sous une forme programmable opérant avec des microprocesseurs ou microcontrôleurs.

Les capteurs de courants sont de préférence des transformateurs de courants. Cependant, d'autres capteurs de courants peuvent convenir par exemple des capteurs à effet Hall ou des magnétorésistances.

Les différents signaux décrits peuvent avoir des formes de signaux électriques ou électroniques, de valeurs de données ou d'information dans des mémoires ou des registres, de signaux optiques visualisables notamment sur des voyants ou des écrans, ou de signaux mécaniques agissant avec des actionneurs.

Les tests décrits ci-dessus peuvent prendre aussi d'autres formes équivalentes notamment selon le sens des opérateurs. De même, la détermination de certains signaux peut prendre plusieurs formes permettant d'obtenir un résultat équivalent.

## Revendications

1.  Dispositif de détection de défaut terre comportant :

    -   des moyens (22) de conditionnement de signal destinés à recevoir des signaux (IA, IB, IC) de courants pour fournir un signal représentatif d'un courant résiduel (Ir) et des signaux (Ia, Ib, Ic) représentatifs de courants de phases, et
    -   des moyens (23) de traitement de signal, connectés aux moyens de conditionnement pour recevoir lesdits signaux représentatifs d'un courant résiduel (Ir) et de courants de phases (Ia, Ib, Ic) et pour fournir un signal (D) de détection de défaut terre si ledit signal (Ir) représentatif de courant résiduel dépasse un premier seuil (S1) prédéterminé,

    dispositif **caractérisé en ce que** lesdits moyens (23) de traitement signalent un défaut terre aval si une valeur dudit signal (Ir) représentatif de courant résiduel dépasse un premier seuil (S1) prédéterminé, et si un rapport entre une valeur représentative de d'amplitude du courant inverse (Ii) et une valeur représentative d'un signal de courant résiduel (Ir) dépasse au moins un second seuil (S2) prédéterminé.

2.  Dispositif selon la revendication 1 **caractérisé en ce que** lesdits moyens de traitement signalent un défaut terre aval si une valeur dudit signal (Ir) représentatif de courant résiduel dépasse ledit premier seuil (S1) prédéterminé, et si un rapport entre une valeur représentative de d'amplitude du courant inverse (Ii) et une valeur représentative d'un signal de courant résiduel (Ir) dépasse au moins ledit second seuil (S2) prédéterminé et est inférieure à un troisième seuil prédéterminé (S3).

3.  Dispositif selon la revendication 2 **caractérisé en ce que** lesdits moyens de traitement comportent :

    -   des premiers moyens (25) de protection pour recevoir le signal (Ir) représentatif de courant résiduel et pour fournir un premier signal (D1) de détection si une valeur du signal de courant résiduel dépasse un premier seuil (S1) prédéterminé, et
    -   des seconds moyens (30, 35, 36, 37, 38) de protection comportant des moyens (35) de détermination d'un courant inverse (Ii) connectés aux moyens de conditionnement (22) pour recevoir lesdits signaux représentatifs de courants de phases (Ia, Ib, Ic) et pour fournir un signal (Ii) représentatif d'un courant inverse, lesdits seconds moyens de protection (30) fournissant un second signal (D2) de détection si un rapport entre une valeur représentative de d'amplitude du courant inverse (Ii) et une valeur représentative d'un signal de courant résiduel (Ir) est compris entre au moins ledit second seuil (S2) prédéterminé et ledit troisième seuil prédéterminé (S3),

    ledit signal (D) de détection de défaut terre aval étant fourni si au moins ledit premier signal (D1) de détection et ledit second signal (D2) de détection sont actifs.

4.  Dispositif selon l'une des revendications 2 ou 3 **caractérisé en ce que** ledit second seuil (S2) prédéterminé correspondant à un rapport entre une valeur représentative de d'amplitude du courant inverse (Ii) et une valeur représentative d'un signal de courant résiduel (Ir) est inférieur à 1 et ledit troisième seuil (S3) prédéterminé correspondant aussi à un rapport entre une valeur représentative de d'amplitude du courant inverse (Ii) et une valeur représentative d'un signal de courant résiduel (Ir) est supérieur à 1,2.

5. Dispositif selon l'une quelconque des revendications 2 à 4 **caractérisé en ce que** lesdits moyens de traitement comportent des troisièmes moyens (40) de protection comportant des moyens (41) de détermination d'une valeur représentative d'un courant direct (Id) connecté aux moyens de conditionnement pour recevoir lesdits signaux représentatifs de courants de phases (Ia, Ib, Ic) et pour fournir un signal (ΔId) représentatif d'une variation d'un courant direct (Id), lesdits troisièmes moyens de protection fournissant un troisième signal (D3) de détection si une valeur représentative dudit courant direct ne diminue pas, ledit signal (D) de détection de défaut terre aval étant fourni si au moins ledit premier signal (D1) de détection, ledit second signal (D2) de détection, et ledit troisième signal (D3) de détection sont actifs.

6. Dispositif selon l'une quelconque des revendications 1 à 5 **caractérisé en ce que** lesdits moyens de conditionnement comportent des moyens (60, 61) de détermination d'un courant résiduel (Ir) en fonction de courants secondaires fournis par des capteurs de courants (20A, 20B, 20C) de phases et des moyens (33) de détermination d'un signal (H2) représentatif d'un harmonique de rang deux d'au moins un signal de courant de phase, et **en ce que** lesdits moyens de traitement (23) comportent des quatrièmes moyens (63) de protection connectés aux moyens de conditionnement pour recevoir le signal (H2) représentatif d'un harmonique de rang deux et pour fournir un signal (64) d'inhibition temporaire à l'enclenchement si ledit signal (H2) représentatif d'un harmonique de rang deux est détecté, ledit signal (D) de détection de défaut terre aval n'étant pas fourni pendant une durée prédéterminée si le signal (H2) représentatif d'un harmonique de rang deux est détecté à l'enclenchement.

7. Dispositif selon la revendication 6 **caractérisé en ce que** ledit signal (H2) représentatif d'un harmonique de rang deux est représentatif d'un taux d'harmonique de rang deux dans une combinaison des courants des trois phases.

8. Dispositif selon l'une des revendications 6 ou 7 **caractérisé en ce qu'**il comporte un capteur (60) de courant secondaire pour fournir un signal (Ir) représentatif d'un courant résiduel mesuré sur des enroulements sorties des capteurs (20A, 20B, 20C) de courants de phases.

9. Dispositif selon l'une des revendications 6 ou 7 **ca-**

**ractérisé en ce que** les moyens (61) de détermination d'un courant résiduel déterminent ledit signal (Ir) représentatif d'un courant résiduel en fonction des signaux (Ia, Ib, Ic) de courants de phases.

10. Relais de protection terre comportant des capteurs (20A, 20B, 20C) de courant disposés sur chaque conducteur (82) de phase d'un circuit d'un réseau électrique à surveiller **caractérisé en ce qu'**il comporte au moins un dispositif de détection de défaut terre selon l'une quelconque des revendications 1 à 9 connecté audits capteurs de courant pour recevoir des signaux (IA, IB, IC) représentatifs de courants de phases et des moyens (65) d'actionnement connectés audit dispositif de détection de défaut terre.

11. Relais de protection selon la revendication 10 **caractérisé en ce qu'**il comporte :

    - un transformateur (21) de courant résiduel entourant les conducteurs (82) de phase d'un réseau à surveiller et comportant un enroulement secondaire connecté audit dispositif de détection de défaut terre pour fournir un signal (IR) représentatif de courant résiduel, et
    - des moyens (83) pour prendre en compte un signal (64) d'inhibition fourni par des quatrièmes moyens de protection (63).

12. Procédé de détection de défaut terre comportant :

    - une étape (70) de conditionnement de signal pour fournir un signal représentatif d'un courant résiduel (Ir) et des signaux représentatifs de courant de phases (Ia, Ib, Ic), et
    - une étape (79) de traitement pour signaler une détection de défaut terre aval en fonction desdits signaux représentatifs de courants de résiduel et de phases,

    **caractérisé en ce qu'**il comporte :

    - une première étape (72) de protection effectuant un premier test pour tester si un signal (Ir) représentatif d'un courant résiduel dépasse un premier seuil (D2) prédéterminé, et
    - une seconde étape (74) de protection effectuant un second test pour tester si un rapport entre un signal (Ii) représentatif d'un courant inverse et un signal (Ir) représentatif d'un courant résiduel dépasse un second seuil (S2) prédéterminé,

    l'étape (79) de traitement signalant une de détection de défaut terre aval si le premier test et le second test sont vrais.

**13.** Procédé de détection selon la revendication 12 **caractérisé en ce que** la seconde étape (74) de protection effectuant un second test pour tester si un rapport entre un signal (Ii) représentatif d'un courant inverse et un signal (Ir) représentatif d'un courant résiduel est compris entre ledit second seuil (S2) prédéterminé et un troisième seuil (S3) prédéterminé.

**14.** Procédé de détection selon l'une des revendications 12 ou 13 **caractérisé en ce qu'**il comporte une troisième étape (77) de protection effectuant un troisième test pour tester si un signal (Id) représentatif d'un courant direct ne décroît pas lors de la détection d'un défaut terre, l'étape (79) de traitement de signal signalant une détection de défaut terre aval si le premier test, le second test et le troisième test sont vrais.

**15.** Procédé de détection selon l'une quelconque des revendications 12 à 14 **caractérisé en ce qu'**il comporte une quatrième étape (75) de protection pour effectuer une inhibition temporaire la signalisation de la détection de défaut terre aval si un enclenchement est détecté.

**FIG. 1 (Art Antérieur)**

**FIG. 2 (Art Antérieur)**

**FIG. 3 (Art Antérieur)**

20A
20B
20C

82

21

32

22

33

$I_r$

25

23

Ir > S1

D1

31

Ia
Ib
Ic

$$S3 > \frac{I_i}{I_r} > S2$$

30

D2

&

D

**FIG. 4**

33

34r

Ir

Ir

25

23

|Ir| > S1

D1

31

34A

Ia

Ia

34B

Ib

Ib

Ii

Ii

37

38

$$\frac{|Ii|}{|Ir|}$$

$$S3 > \frac{|Ii|}{|Ir|} > S2$$

34C

Ic

Ic

36

35

30

D2

&

D

**FIG. 5**

**FIG. 6**

**FIG. 7**

**FIG. 8**

**FIG. 9**

**FIG. 10**

Conditionnement de signaux
Ir, Ia, Ib, Ic — 70

↓

Traitement des signaux
Ir, Ii, Id, △Id, H2 — 71

↓

|Ir| > S1 ? — 72    → Non

↓ Oui

S2 < |Ii| / |Ir| < S3 ? — 74    → Non

↓ Oui

H2 > S5 ? — 75    → Oui

↓ Non

Enclenchement ? — 76    → Oui

↓ Non

△Id < S4 ? — 77    → Oui

↓ Non

Autres tests — 78

↓

Détection défaut terre aval — 79

Pas de détection défaut terre aval — 73

14

**Office européen des brevets**

# RAPPORT DE RECHERCHE EUROPEENNE

Numéro de la demande

EP 04 35 4016

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | EP 1 104 070 A (CANON KK) 30 mai 2001 (2001-05-30) * abrégé * | 1,12 | H02H3/347 |
| A | EP 1 003 263 A (SCHNEIDER ELECTRIC IND SA) 24 mai 2000 (2000-05-24) * abrégé * | 1,12 | |
| A | FR 2 538 179 A (MERLIN GERIN) 22 juin 1984 (1984-06-22) * abrégé * | 1,12 | |

| | DOMAINES TECHNIQUES RECHERCHES (Int.Cl.7) |
|---|---|
| | H02H |

Le présent rapport a été établi pour toutes les revendications

| Lieu de la recherche | Date d'achèvement de la recherche | Examinateur |
|---|---|---|
| La Haye | 22 juillet 2004 | Salm, R |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
 
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 04 35 4016

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

22-07-2004

| Document brevet cité au rapport de recherche | | Date de publication | Membre(s) de la famille de brevet(s) | | Date de publication |
|---|---|---|---|---|---|
| EP 1104070 | A | 30-05-2001 | AU | 755700 B2 | 19-12-2002 |
| | | | AU | 7184500 A | 31-05-2001 |
| | | | EP | 1104070 A2 | 30-05-2001 |
| | | | JP | 2001224129 A | 17-08-2001 |
| | | | US | 2003067724 A1 | 10-04-2003 |
| | | | US | 6556396 B1 | 29-04-2003 |
| EP 1003263 | A | 24-05-2000 | FR | 2786040 A1 | 19-05-2000 |
| | | | EP | 1003263 A1 | 24-05-2000 |
| FR 2538179 | A | 22-06-1984 | FR | 2538179 A1 | 22-06-1984 |

EPO FORM P0460